(19) Europäisches Patentamt
European Patent Office
Office européen des brevets

(11) **EP 3 006 948 A1**

(12) **EUROPEAN PATENT APPLICATION**

(43) Date of publication:
13.04.2016 Bulletin 2016/15

(51) Int Cl.:
*G01R 31/333* (2006.01) *H02M 7/483* (2007.01)

(21) Application number: 14275212.0

(22) Date of filing: 07.10.2014

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicant: ALSTOM Technology Ltd
5400 Baden (CH)

(72) Inventors:
• TRAINER, David Reginald
Alvaston
Derby DE24 0AQ (GB)

• DANG, Si
Stafford
ST16 2EB (GB)
• MORENO MUÑOZ, Francisco Jose
Stafford
ST16 2QZ (GB)
• OATES, Colin Donald Murray
Brocton
Staffordshire ST17 0TL (GB)

(74) Representative: Potter Clarkson LLP
The Belgrave Centre
Talbot Street
Nottingham NG1 5GG (GB)

(54) **Synthetic test circuit**

(57) There is an apparatus (30) for constructing a synthetic test circuit. The apparatus comprising an assembly of electrically interconnected elements (32), at least one of the electrically interconnected elements (32) being or including a chain-link converter, the chain-link converter including a plurality of modules, each module including at least one energy storage device, wherein each of the electrically interconnected elements (32) is configurable to be selectively bypassed, disconnected and/or connected to construct, in use, a synthetic test circuit including at least one of the electrically intercon-
nected elements (32) and in which the synthetic circuit includes: a terminal connectable to a device under test; and an injection circuit operably connected to the terminal, the injection circuit including a source, the source including the chain-link converter, each module being operable to be selectively bypassed and inserted into the corresponding chain-link converter so as to generate a voltage across the chain-link converter and thereby enable the injection circuit to inject a current waveform and/or a voltage waveform into the device under test.

Figure 1

**Description**

The invention relates to an apparatus for constructing a synthetic test circuit, and to a synthetic test circuit.

It is known to employ a synthetic test circuit to test an electrical component that is for use in HVDC power transmission. The term "synthetic" is used to describe the test circuit because the test circuit does not form part of an actual HVDC station converter, i.e. the electrical component under test is not connected into the actual HVDC station converter which transfers significant real power.

According to a first aspect of the invention, there is provided an apparatus for constructing a synthetic test circuit, the apparatus comprising an assembly of electrically interconnected elements, at least one of the electrically interconnected elements being or including a chain-link converter, the chain-link converter including a plurality of modules, each module including at least one energy storage device, wherein each of the electrically interconnected elements is configurable to be selectively bypassed, disconnected and/or connected to construct, in use, a synthetic test circuit including at least one of the electrically interconnected elements and in which the synthetic circuit includes: a terminal connectable to a device under test; and an injection circuit operably connected to the terminal, the injection circuit including a source, the source including the chain-link converter, each module being operable to be selectively bypassed and inserted into the corresponding chain-link converter so as to generate a voltage across the chain-link converter and thereby enable the injection circuit to inject a current waveform and/or a voltage waveform into the device under test.

The assembly of electrically interconnected elements effectively defines a flexible circuit structure for the construction of the synthetic test circuit by way of bypass, disconnection and/or connection of each of the electrically interconnected elements, and therefore easily allows a variety of different possible configurations of the synthetic test circuit to be constructed.

The apparatus according to the invention therefore provides an effective means for constructing the synthetic test circuit to suit the testing requirements of a given device under test but also for re-constructing the synthetic test circuit to suit the testing requirements of a different device under test. This renders the apparatus compatible with multiple devices under test with different testing requirements and thereby obviates the need to build separate synthetic test circuits for performing different electrical tests, which would add cost, size and weight to the associated infrastructure.

In addition the apparatus according to the invention facilitates the construction of a synthetic test circuit with at least one injection circuit based on a chain-link converter, and thereby facilitates creation of a synthetic test circuit with the advantages associated with the or each injection circuit based on the chain-link converter.

The structure of the chain-link converter (which may, for example, comprise a plurality of series-connected modules) permits build-up of a combined voltage across the chain-link converter, which is higher than the voltage available from each of its individual modules, via the insertion of the energy storage devices of multiple modules, each providing its own voltage, into the chain-link converter. In this manner the chain-link converter is capable of providing a stepped variable voltage source, which permits the generation of a voltage waveform across the chain-link converter using a step-wise approximation. As such the chain-link converter is capable of providing complex voltage waveforms to enable the injection circuit to inject a wide range of current waveforms and/or voltage waveforms into the device under test, and so enables the synthetic test circuit to readily and reliably create test current and/or voltage conditions that are identical or closely similar to actual in-service current and/or voltage conditions.

The capability of the chain-link converter to generate a voltage waveform thereacross using a step-wise approximation allows the injection circuit to inject current waveforms and/or voltage waveforms of varying levels into the device under test, and thus renders the synthetic test circuit capable of electrically testing various devices across a wide range of ratings.

Furthermore the modular arrangement of the chain-link converter means that the number of modules in the chain-link converter can be readily scaled up or down to modify the voltage capability of the chain-link converter to match the testing requirements of the device under test, without having to make significant changes to the overall design of the synthetic test circuit.

The provision of the chain-link converter in the injection circuit therefore results in a synthetic test circuit that is not only capable of performing high quality electrical testing, but also has the flexibility to perform an electrical test on a broad range of devices with different ratings.

In embodiments of the invention, the synthetic test circuit may include a current injection circuit and/or a voltage injection circuit. The construction of the synthetic test circuit from the assembly of electrically interconnected elements may be optimised to include either or both of the current and voltage injection circuits depending on the testing requirements of the device under test.

The structure of the chain-link converter may vary depending on the testing requirements of the device under test.

The chain-link converter may include at least one module in which the or each energy storage device is configured to selectively provide a bidirectional voltage source and/or at least one module in which the or each energy storage device is configured to selectively provide a unidirectional voltage source.

The provision of a bidirectional voltage source in the chain-link converter permits operation of the chain-link converter to generate a bidirectional voltage waveform thereacross. This not only permits injection of a bidirectional voltage waveform into the device under test, but also permits configuration of the chain-link converter to have a symmetric voltage capability, i.e. the capability to apply equal magnitudes of positive and negative voltages.

Meanwhile the provision of a unidirectional voltage source in the chain-link converter permits operation of the chain-link converter to generate a unidirectional voltage waveform thereacross and thereby results in an optimised configuration of the chain-link converter for injecting a unidirectional voltage waveform into the device under test.

The provision of at least one module in which the or each energy storage device is configured to selectively provide a bidirectional voltage source and at least one module in which the or each energy storage device is configured to selectively provide a unidirectional voltage source in the chain-link converter permits configuration of the chain-link converter to have an asymmetric voltage capability, i.e. the capability to apply different magnitudes of positive and negative voltages.

In embodiments of the invention, each of a plurality of the electrically interconnected elements may be or may include a chain-link converter. In such embodiments of the invention, each of the electrically interconnected elements may be configurable to be selectively bypassed, disconnected and/or connected to construct the synthetic test circuit in which the injection circuit includes a plurality of series-connected or parallel-connected sources, each source including a respective one of the plurality of chain-link converters.

The provision of each of a plurality of the electrically interconnected elements in the form of a chain-link converter provides further flexibility when it comes to constructing the synthetic test circuit. For example, the provision of multiple chain-link converters permits construction of a synthetic test circuit with multiple injection circuits, or construction of a synthetic test circuit with an injection circuit having increased current and/or voltage ratings.

In further embodiments of the invention, at least one other of the electrically interconnected elements may be or may include a switching element. Optionally the switching element may be a naturally commutated or self-commutated switching element.

The provision of at least one other electrically interconnected element in the form of a switching element permits formation of a current path in the constructed synthetic test circuit in which the current path is switchable to selectively permit and block current flow. This in turn permits operation of the synthetic test circuit to perform a variety of functions, examples of which are set out as follows.

The synthetic test circuit may be constructed to permit selective bypass, isolation or connection of the injection circuit depending on the testing requirements of the device under test. This may be achieved by way of an embodiment of the invention in which each of the electrically interconnected elements is configurable to be selectively bypassed, disconnected and/or connected to construct the synthetic test circuit in which the switching element is connected in series or parallel with the injection circuit.

The synthetic test circuit may be constructed to permit creation of hard current switching test conditions, i.e. finite current switching test conditions, in order to test the hard current switching capabilities of the device under test. This may be achieved by way of an embodiment of the invention in which each of the electrically interconnected elements is configurable to be selectively bypassed, disconnected and/or connected to construct the synthetic test circuit in which the switching element is operable to selectively form a current bypass path to allow, in use, a current waveform to bypass the device under test.

Optionally at least one other of the electrically interconnected elements may be or may include an impedance element, such as an inductor.

The provision of at least one other electrically interconnected element in the form of an impedance element permits construction of a synthetic test circuit that includes a current control element for improving control over the injection of a current waveform into the device under test. This may be achieved by way of an embodiment of the invention in which each of the electrically interconnected elements is configurable to be selectively bypassed, disconnected and/or connected to construct the synthetic test circuit in which the source of the injection circuit includes an interconnection of the impedance element and the chain-link converter.

In embodiments of the invention employing the use of electrically interconnected elements in the form of an impedance element and a switching element, each of the electrically interconnected elements may be configurable to be selectively bypassed, disconnected and/or connected to construct the synthetic test circuit in which the source of the injection circuit includes an interconnection of the impedance element and the switching element, the switching element being operable to selectively form a current bypass path to allow, in use, a current waveform to bypass the impedance element. This permits construction of a synthetic test circuit in which the impedance element is selectively bypassed and connected during the electrical test depending on the testing requirements of the device under test.

Optionally at least one other of the electrically interconnected elements may be or may include a power supply unit. Each of the electrically interconnected elements may be configurable to be selectively bypassed, disconnected and/or connected to construct the synthetic test circuit in which the power supply unit is coupled to the chain-link converter so as to permit the power supply unit to selectively charge the or each energy storage device.

The construction of the synthetic test circuit to include a power supply unit may be carried out in different ways, examples of which are set out as follows. In one such example, each of the electrically interconnected elements may be configurable to be selectively bypassed, disconnected and/or connected to construct the synthetic test circuit in which the power supply unit is directly coupled with the or each energy storage device of each module. In another such example, each of the electrically interconnected elements may be configurable to be selectively bypassed, disconnected and/or connected to construct the synthetic test circuit in which the power supply unit is connected with the chain-link converter in the injection circuit.

According to a second aspect of the invention, there is provided a synthetic test circuit for performing an electrical test on a device under test, the synthetic test circuit including an apparatus according to any embodiment of the first aspect of the invention.

The synthetic test circuit according to the second aspect of the invention may further include a controller. The controller may be configured to operate each module to selectively bypass the or each corresponding energy storage device and insert the or each corresponding energy storage device into the corresponding chain-link converter so as to generate a voltage across the chain-link converter and thereby operate the injection circuit to inject a current waveform and/or a voltage waveform into the device under test.

A preferred embodiment of the invention will now be described, by way of a non-limiting example only, with reference to the accompanying drawings in which:

Figure 1 shows schematically an apparatus according to an embodiment of the invention;
Figure 2 shows schematically elements of an assembly of electrically interconnected elements forming part of the apparatus of Figure 1;
Figure 3 shows schematically examples of devices under test;
Figures 4 and 5 show schematically converters for use in HVDC power transmission;
Figures 6 to 8 show schematically a first constructed synthetic circuit and its operation;
Figure 9 shows schematically a second constructed synthetic test circuit and its operation;
Figure 10 illustrates actual in-service voltage conditions for a thyristor valve when it is used in a rectifier; and
Figure 11 to 20 show schematically third to tenth constructed synthetic test circuits and their operation.

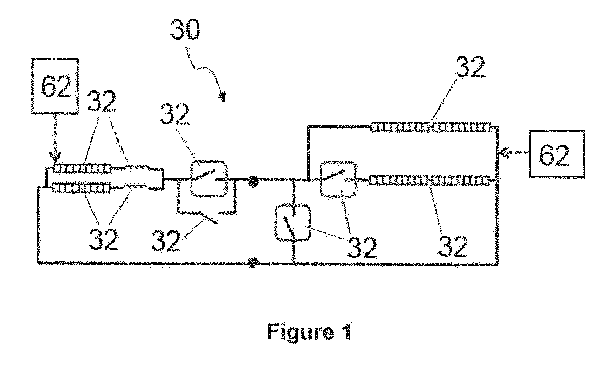

An apparatus according to an embodiment of the invention is shown in Figure 1, and is designated generally by the reference numeral 30.

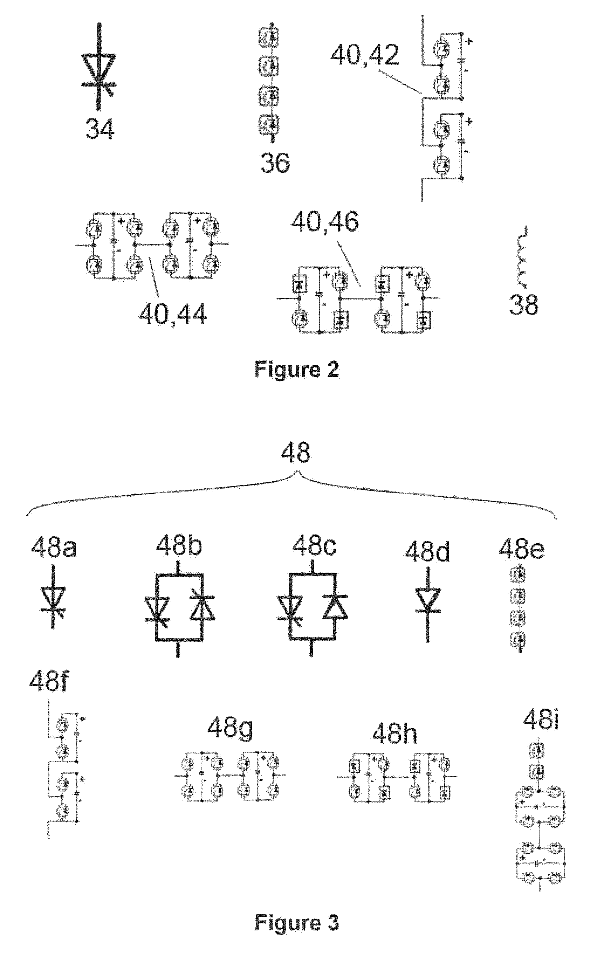

The apparatus 30 is for constructing a synthetic test circuit that is for performing an electrical test on a device under test. The apparatus 30 comprises an assembly of electrically interconnected elements 32, each of which is selected from a group including, as shown in Figure 2:

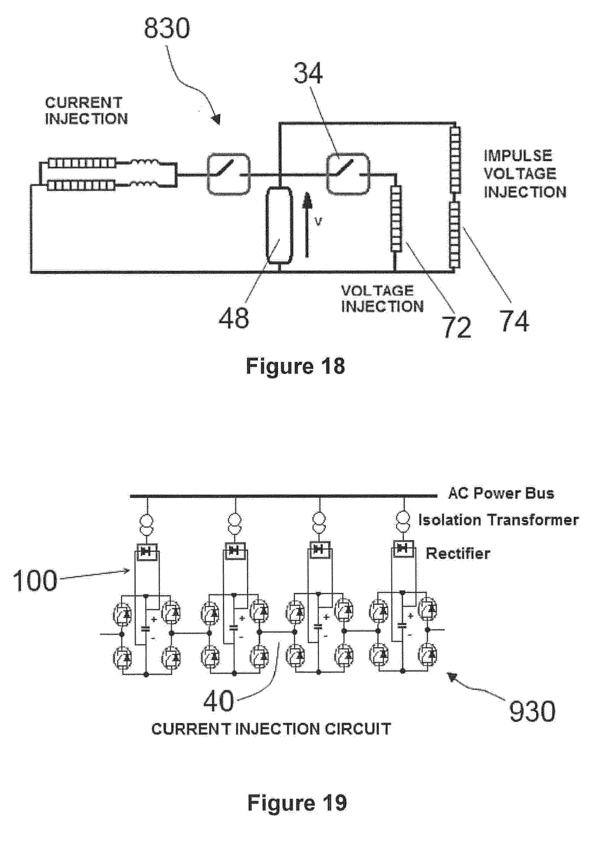

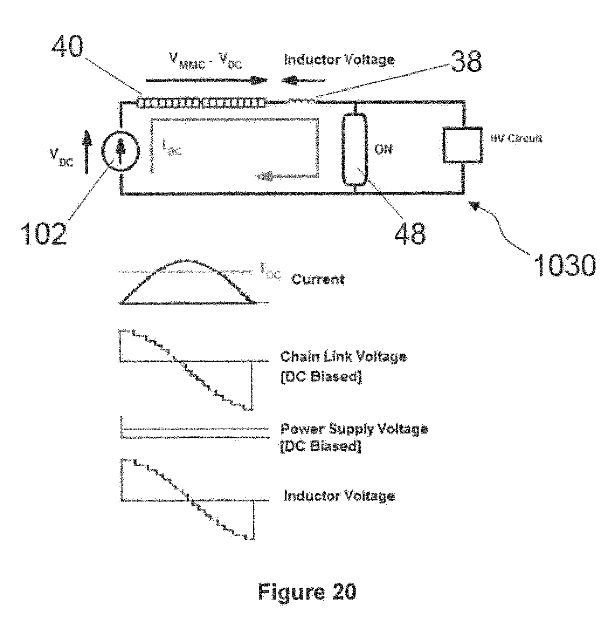

- a thyristor valve 34;
- a director switch 36 in the form of a string of insulated gate bipolar transistors (IGBT), each of which is connected in parallel with an anti-parallel diode. Alternatively the director switch may be in the form of a single IGBT connected in parallel with an anti-parallel diode;
- an inductor 38;
- a chain-link converter 40 including a plurality of series-connected 2-quadrant unipolar modules 42;
- a chain-link converter 40 including a plurality of series-connected 4-quadrant bipolar modules 44;
- a chain-link converter 40 including a plurality of series-connected rationalised modules 46;
- a power supply unit 100,102 (refer to Figures 19 and 20).

Each 2-quadrant unipolar module 42 includes a pair of module switches and an energy storage device in the form of a capacitor. In each 2-quadrant unipolar module 42, the pair of module switches is connected in parallel with the capacitor in a half-bridge arrangement to define the 2-quadrant unipolar module 42 that can provide zero or positive voltages and can conduct current in two directions.

The capacitor of each 2-quadrant unipolar module 42 is selectively bypassed and inserted into the chain-link converter 40 by changing the states of the corresponding module switches. This selectively directs current through the capacitor or causes current to bypass the capacitor so that the 2-quadrant unipolar module 42 provides a zero or positive voltage.

The capacitor of the 2-quadrant unipolar module 42 is bypassed when the module switches are configured to form a current path that causes current in the chain-link converter 40 to bypass the capacitor, and so the 2-quadrant unipolar module 42 provides a zero voltage, i.e. the 2-quadrant unipolar module 42 is configured in a bypassed mode.

The capacitor of the 2-quadrant unipolar module 42 is inserted into the chain-link converter 40 when the module switches are configured to allow the current in the chain-link converter 40 to flow into and out of the capacitor. The capacitor then charges or discharges its stored energy so as to provide a positive voltage, i.e. the 2-quadrant unipolar module 42 is configured in a non-bypassed mode.

Each 4-quadrant bipolar module 44 includes two pairs of module switches and an energy storage device in the form of a capacitor. In each 4-quadrant bipolar module 44, the pairs of module switches are connected in parallel with the capacitor in a full-bridge arrangement to define the 4-quadrant bipolar module 44 that can provide negative, zero or positive voltages and can conduct current in two directions.

The capacitor of each 4-quadrant bipolar module 44 is selectively bypassed and inserted into the chain-link converter 40 by changing the states of the corresponding module switches. This selectively directs current through the capacitor or causes current to bypass the capacitor so that the 4-quadrant bipolar module 44 provides a negative, zero or positive voltage.

The capacitor of the 4-quadrant bipolar module 44 is bypassed when the module switches are configured to form a current path that causes current in the respective chain-link converter 40 to bypass the capacitor, and so the 4-quadrant bipolar module 44 provides a zero voltage, i.e. the 4-quadrant bipolar module 44 is configured in a bypassed mode.

The capacitor of the 4-quadrant bipolar module 44 is inserted into the chain-link converter 40 when the module switches are configured to allow the current in the chain-link converter 40 to flow into and out of the capacitor. The capacitor then charges or discharges its stored energy so as to provide a non-zero voltage, i.e. the 4-quadrant bipolar module 44 is configured in a non-bypassed mode. The full-bridge arrangement of the module switches permits configuration of the module switches to cause current to flow into and out of the capacitor in either direction, and so each 4-quadrant bipolar module 44 can be configured to provide a negative or positive voltage in the non-bypassed mode.

Each rationalised module 46 has first and second sets of series-connected current flow control elements and an energy storage device in the form of a capacitor. The first and second sets of series-connected current flow control elements are connected in parallel with the capacitor in a full-bridge arrangement. Each set of current flow control elements includes a module switch connected in series with a diode.

The capacitor of each rationalised module 46 is selectively bypassed or inserted into the corresponding chain-link converter 40 by changing the states of the current flow control elements. This selectively directs current through the capacitor or causes current to bypass the capacitor, so that the rationalised module 46 provides a negative, zero or positive voltage.

The capacitor of the rationalised module 46 is bypassed when the current flow control elements in the rationalised module 46 are configured to form a short circuit in the rationalised module 46. This causes current in the corresponding chain-link converter 40 to pass through the short circuit and bypass the capacitor, and so the rationalised module 46 provides a zero voltage, i.e. the rationalised module 46 is configured in a bypassed mode.

The capacitor of the rationalised module 46 is inserted into the chain-link converter 40 when the current flow control elements in the rationalised module 46 are configured to allow the current in the chain-link converter 40 to flow into and out of the capacitor. The capacitor then charges or discharges its stored energy so as to provide a non-zero voltage, i.e. the rationalised module 46 is configured in a non-bypassed mode. The full-bridge arrangement of the rationalised module 46 permits configuration of the current flow control elements in the rationalised module 46 to cause current to flow into and out of the capacitor in either direction, and so the rationalised module 46 can be configured to provide a negative or positive voltage in the non-bypassed mode.

Meanwhile the series connection of the diode and module switch of each set of current flow control elements in the rationalised module 46 limits the flow of current through the rationalised module 46 to a single direction.

The structure of each chain-link converter 40 permits build-up of a combined voltage across each chain-link converter 40, which is higher than the voltage available from each of its individual modules, via the insertion of the capacitors of multiple modules, each providing its own voltage, into each chain-link converter 40. In this manner each chain-link converter 40 is capable of providing a stepped variable voltage source, which permits the generation of a voltage waveform across each chain-link converter 40 using a step-wise approximation. As such each chain-link converter 40 is capable of providing complex voltage waveforms.

It will be appreciated that the number of modules in each chain-link converter 40 may vary depending on the testing requirements of the device under test.

Each module switch constitutes an insulated gate bipolar transistor (IGBT) that is connected in anti-parallel with a diode. It is envisaged that, in other embodiments of the invention, each IGBT may be replaced by a gate turn-off thyristor, a field effect transistor, an injection-enhanced gate transistor, an integrated gate commutated thyristor or any other self-commutated switching device.

It is envisaged that, in other embodiments of the invention, each capacitor may be replaced by another type of energy storage device that is capable of storing and releasing energy, e.g. a battery or fuel cell.

In use, each of the electrically interconnected elements 32 is configurable to be selectively bypassed, disconnected and/or connected to construct the synthetic test circuit that includes at least one of the electrically interconnected elements 32. In addition the synthetic test circuit is constructed to include at least one terminal connectable to the device under test; and at least one injection circuit operably connected to the terminal(s). The or each injection circuit is constructed to include a source that in turn includes at least one chain-link converter 40.

It is envisaged that, in other embodiments, each element may be replaced by another type of element with identical or similar functionality. The thyristor valve 34 may be replaced by another type of naturally commutated switching element. The IGBT may be replaced by another type of self-commutated switching element. The inductor 38 may be replaced by another type of impedance element. Each chain-link converter 40 may be replaced by a chain-link converter having a combination of different modules, e.g. a chain-link converter having a plurality of series-connected 2-quadrant unipolar modules 42 and 4-quadrant bipolar modules 44. Each chain-link converter 40 may be replaced by another type of chain-link converter including a plurality of modules, each module including at least one capacitor.

Examples of devices under test 48 are shown schematically in Figure 3, and each device under test 48 is selected from a group including:

- a thyristor valve 48a;
- a pair of anti-parallel connected thyristor valves 48b;
- a thyristor valve connected in parallel with an anti-parallel diode 48c;
- a diode 48d;
- a director switch 48e including a string of IGBTs, each of which is connected in parallel with an anti-parallel diode;
- a chain-link converter 48f including a plurality of series-connected 2-quadrant unipolar modules;
- a chain-link converter 48g including a plurality of series-connected 4-quadrant bipolar modules;
- a chain-link converter 48h including a plurality of series-connected rationalised modules;
- a director switch connected in series with a chain-link converter 48i;
- a combination thereof.

Each of the devices under test 48 shown in Figure 3 may be used in a converter that is for use in HVDC power transmission.

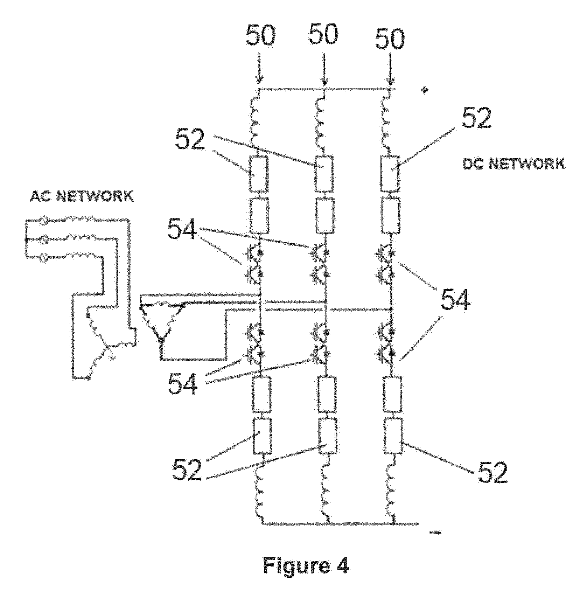

Figure 4 shows schematically an Alternate Arm Converter (ACC) for use in HVDC power transmission.

The AAC includes a plurality of converter limbs 50, each of which extends between first and second DC terminals and includes first and second limb portions separated by a respective AC terminal. Each limb portion includes a chain-link converter 52 connected in series with a director switch 54. Each chain-link converter 52 includes a plurality of series-connected modules, each of which may be in the form of a 2-quadrant unipolar module, a 4-quadrant bipolar module or a rationalised module. In use, each director switch 54 is operable to switch the corresponding limb portion into and out of circuit between the AC terminal and the corresponding one of the first and second DC terminals.

The voltage experienced by each director switch 54 at its commutation may be either a zero (or substantially zero) voltage or a non-zero voltage depending on the reactive power being exchanged with an AC network connected to the AC terminals of the AAC. If the reactive power exchanged with the AC network is zero (or substantially zero), then the voltage experienced by each director switch 54 at its commutation is a zero (or substantially zero) voltage. If the reactive power exchanged with the AC network is non-zero, then the voltage experienced by each director switch 54 at its commutation is a non-zero voltage.

Therefore, during operation of the AAC, each director switch 54 experiences either soft current switching and soft voltage switching, or soft current switching and hard voltage switching.

During switching of each limb portion of the AAC, each limb portion starts and ends conduction at zero current on a repetition cycle, typically at a frequency of 50 Hz. Whilst each limb portion starts and ends conduction at zero current, each module of the chain-link converter 52 is switched in and out of circuit to generate a sinusoidal voltage waveform at the respective AC terminal. The IGBTs and diodes within each module are switched on and off, with each IGBT and diode experiencing hard voltage commutation at the capacitor voltage (which is typically 2 kV). The IGBTs and diodes switch on and off at different times and thus can switch at a current flowing in the corresponding limb portion ranging from zero current to a peak current value, e.g. 1500 A.

The converter components 52,54 of the converter therefore experience a wide range of actual in-service current and voltage conditions during its use in the AAC arrangement.

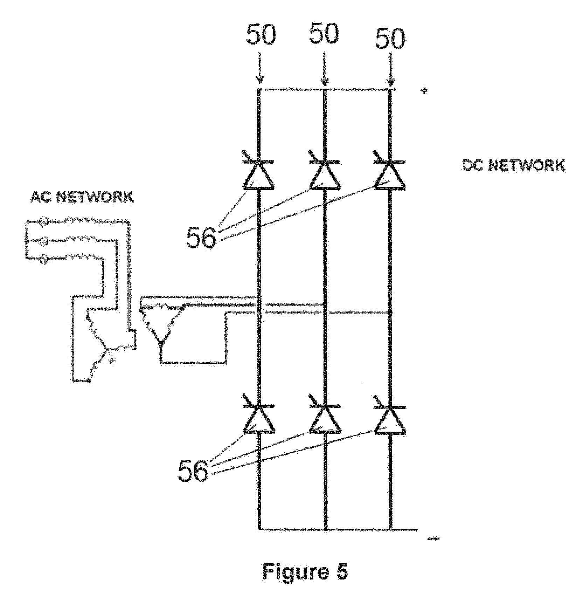

Figure 5 shows schematically a Line-Commutated Converter (LCC) for use in HVDC power transmission.

The LCC includes a plurality of converter limbs 50, each of which extends between first and second DC terminals and includes first and second limb portions separated by a respective AC terminal. Each limb portion includes a thyristor valve 56. In use, the instantaneous AC voltage at the respective AC terminal turns each thyristor valve 56 on and off to switch the corresponding limb portion into and out of circuit between the AC terminal and the corresponding one of the first and second DC terminals.

Each converter component 52,54,56 can conduct different current waveforms depending on the structure and operation of the converter arrangement. The steady-state current waveform conducted by each converter component 52,54,46 can be a complex current waveform that includes direct current, a fundamental frequency alternating current and/or one or more harmonic components, and can have a duty cycle ranging from 120 electrical degrees (LCC) to 240 electrical degrees (AAC with an extended over-lap) at a frequency of 50 or 60Hz. In addition each converter component 52,54,46 may conduct either a unidirectional direct current or a bidirectional alternating current depending on the converter arrangement and associated converter application.

The converter components 52,54,56 in a converter arrangement may, under emergency or abnormal conditions, be exposed to various actual in-service current and voltage conditions on a single-shot and infrequent basis.

The converter components 52,54,56 therefore experience a wide range of actual in-service current and voltage conditions during its use in a converter arrangement.

Typically each converter component 52,54,56 must comply with various testing requirements, which are identical or closely similar to actual in-service current and voltage conditions, in order to be certified for service operation.

In order to check whether each converter component 52,54,56 complies with current testing requirements, the constructed synthetic test circuit is controlled to perform an electrical test on the corresponding device under test 48 that involves creation of test current conditions including one or more of:

- injection of a current waveform with a target polarity (i.e. positive and/or negative polarity);
- injection of a current waveform with a specific shape, e.g. a current waveform that includes direct current, a fundamental frequency alternating current and/or one or more harmonic components;
- injection of a current waveform with a specific duty cycle;
- repetitive cycling of current loading of the device under test 48 at a selected frequency (e.g. 50 or 60 Hz);
- application of a selected rate of change of current;
- soft (zero) current turn-on and/or soft current turn-off of the device under test 48;
- hard (non-zero) current turn-on and/or hard current turn-off of the device under test 48;
- provision of real power to the device under test 48 (e.g. to study losses in the device under test 48);
- storage of a selected amount of inductive energy for transfer to the device under test 48 during its turn-off or blocking state.

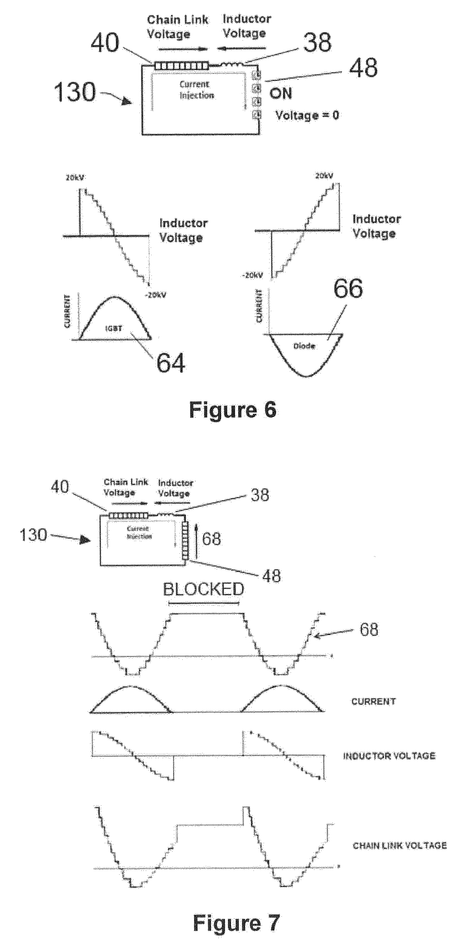

Creation of test current conditions may be achieved by way of a first constructed synthetic test circuit that is shown in Figure 6 and is designated generally by the reference numeral 130.

The first constructed synthetic test circuit 130 is constructed by connecting a chain-link converter 40 in series with the inductor 38, so that the first constructed synthetic test circuit 130 comprises first and second terminals and a current injection circuit in which the current injection circuit includes a current source, and the current source includes a series connection of the chain-link converter 40 and inductor 38; and the current injection circuit is connected across the first and second terminals.

A controller 62 is configured to control switching of the module switches of each module to selectively bypass the corresponding capacitor and insert the corresponding capacitor into the corresponding chain-link converter 40 so as to generate a voltage across the corresponding chain-link converter 40. This enables the current injection circuit to be operated to inject a current waveform into the chain-link converter under test 48. A cycle of such injection of the current waveform may be repeated at a desired frequency (e.g. 50 Hz).

The current waveform required for injection into the device under test 48 is derived by using the chain-link converter 40 to modify a voltage applied across the inductor 38. The inductor 38 can be selected on the basis of its capability to store a selected amount of stored energy as 0.5 LI$^2$.

When the device under test 48 is or includes a switching element (e.g. thyristor valve 48a, diode 48d, director switch 48e), the device under test 48 must be set to its low-impedance on-state in order to conduct the injected current waveform. The voltage waveform to be applied across the inductor 38 in order to achieve a target current waveform for injection into the device under test 48 can be derived using Equation 1.

$$i_L\left(T_s\right) - i_L(0) = \frac{1}{L}\int_0^{T_s} V_L(t)\,dt \quad \cdots\cdots\cdots (1)$$

where $i_L$ is the current flowing through the inductor 38;
$T_s$ is the time at which the current waveform is injected into the device under test 48;
L is the inductance of the inductor 38;
$V_L$ is the voltage applied across the inductor 38.

When the device under test 48 is or includes the director switch 48e, the current injection circuit may be operated to inject a first half-sinusoidal current waveform of a positive polarity into a device under test 48 and to inject a second half-sinusoidal current waveform of a negative polarity into the device under test 48, as shown in Figure 6.

Each half-sinusoidal current waveform is derived through use of the chain-link converter 40 to generate a voltage thereacross and thereby modify a voltage across the inductor 38 so as to control the shape and polarity of the injected current waveform. The voltage across the inductor 38 is controlled to have a zero average component and to start with either a positive section or negative section so as to control the direction of current injected into the device under test 48. In the embodiment shown, the direction of current is positive when the current 64 is required to flow through the IGBTs of the device under test 48, and the direction of current is negative when the current 66 is required to flow through the anti-parallel connected diodes of the device under test 48. This in turn permits creation of test conditions that are identical or closely similar to soft current switching of the device under test 48.

A plurality of cycles of the injection of the half-sinusoidal current waveform into the device under test 48 may be performed to create test conditions that are identical or closely similar to repetitive soft current switching of the device under test 48.

When the device under test 48 is or includes a chain-link converter, the current injection circuit may be operated to generate a bidirectional voltage waveform across the corresponding chain-link converter 40 while the chain-link converter under test 48 is operated to generate a bidirectional voltage waveform 68 thereacross, whereby the generated bidirectional voltage waveform 68 across the chain-link converter under test 48 is identical or closely similar to actual in-service voltage conditions experienced by the chain-link converter 40.

The voltage across the chain-link converter 40 of the current injection circuit and the voltage 68 across the chain-link converter under test 48 combine to control the voltage across the inductor 38 and thereby control the current waveform injected into the chain-link converter under test 48. Hence, in order to provide the voltage across the inductor 38 to inject the current waveform into the chain-link converter under test 48, the chain-link converter 40 of the current injection circuit is operated to generate a voltage waveform thereacross that is the sum of the voltage across the inductor 38 and the voltage 68 across the chain-link converter under test 48, as shown in Figure 7.

To create test current conditions that are identical or closely similar to the actual in-service current conditions in the rectifier mode of the AAC arrangement, the voltage across the inductor 38 is controlled to have a zero average component and to start with a positive section and end with a negative section so as to control the direction of current injected into the chain-link converter under test 48, as shown in Figure 7.

Similarly, to create test current conditions that are identical or closely similar to the actual in-service current conditions in the inverter mode of the AAC arrangement, the voltage across the inductor 38 is controlled to have a zero average component and to start with a negative section and end with a positive section so as to control the direction of current injected into the chain-link converter under test 48.

Hence, the first constructed synthetic test circuit 130 is capable of creating test conditions that are identical or closely similar to actual in-service current and voltage conditions of the chain-link converter 40, which for example takes place during its use in the AAC.

When the chain-link converter under test 48 is generating a voltage waveform thereacross whilst conducting the injected current waveform, real power flows into and out of the chain-link converter under test 48 on an instantaneous basis. Such flow of real power into and out of the chain-link converter under test 48 may result in a net change in energy level of the chain-link converter under test 48 and/or a net change in energy level of the capacitor of each module of the chain-link converter under test 48 due to an export or import of real power.

The chain-link converter under test 48 may be operated to generate a sinusoidal voltage waveform (or any other preferred voltage waveform) thereacross, while the current injection circuit is operated to inject a current waveform into the chain-link converter under test 48, whereby the current waveform is shaped such that the average power flow into the chain-link converter under test 48 is zero in order to obtain a zero net change in energy level of the chain-link converter 40 over an operating cycle. In practice, a power profile corresponding to such a current waveform will have one or more positive power periods, in which the chain-link converter under test 48 experiences a net inflow of power, and one or more negative power periods, in which the chain-link converter under test 48 experiences a net outflow of power.

In addition, whilst the chain-link converter under test 48 is operated to generate a voltage waveform thereacross, the capacitor of each module may be selectively bypassed and inserted into the chain-link converter under test 48 such that each module experience low current and high current switching in set amounts of time required to balance the voltage levels of the capacitors of the modules. For a chain-link converter 40 based on the 4-quadrant bipolar module, the full-bridge arrangement of each module enables each module to be charged and discharged in equal amounts whilst being inserted into the chain-link converter under test 48, and so it becomes possible to operate the chain-link converter under test 48 to selectively bypass and insert each capacitor into the chain-link converter under test 48 in order to control the energy level of the chain-link converter under test 48 to obtain a zero net change in energy level of each module over an operating cycle.

Hence, the first constructed synthetic test circuit 130 is capable of creating test conditions that are identical or closely similar to actual in-service energy balancing conditions of the chain-link converter 48, which for example takes place during its use in the AAC.

In order to check whether each converter component 52,54,56 complies with voltage testing requirements, the constructed synthetic test circuit is controlled to perform an electrical test on the corresponding device under test 48 that involves creation of test voltage conditions including one or more of:

- injection of a voltage waveform with a target polarity (i.e. positive and/or negative polarity);
- injection of a voltage waveform with a specific shape, e.g. a voltage waveform that includes direct voltage, a fundamental frequency alternating voltage and/or one or more harmonic components;
- injection of a voltage waveform with a specific duty cycle;
- repetitive cycling of voltage stressing of the device under test 48 at a selected frequency (e.g. 50 or 60 Hz);
- application of a selected rate of change of voltage;
- soft (zero) voltage turn-on and/or soft voltage turn-off of the device under test 48;
- hard (non-zero) voltage turn-on and/or hard voltage turn-off of the device under test 48;
- provision of real power to the device under test 48 (e.g. to study losses in the device under test 48);
- storage of a selected amount of capacitive energy for transfer to the device under test 48 during its turn-on or conduction state;
- injection of a voltage waveform corresponding to actual in-service voltage conditions for a thyristor valve when it is used in a rectifier.

The construction of a synthetic test circuit with an injection circuit including a chain-link converter 40 permits injection of a range of complex voltage waveforms into the device under test 48. In addition the chain-link converter 40 for use in the injection circuit of the constructed synthetic test circuit may be selected to provide the injection circuit with a symmetric or asymmetric voltage capability.

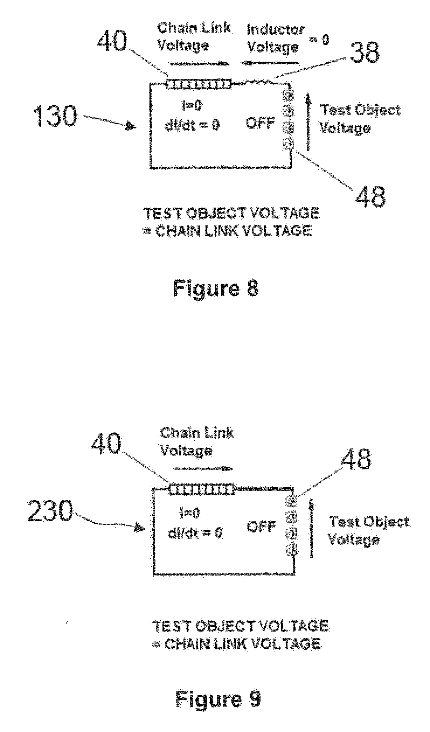

The first constructed synthetic test circuit 130 can be used to inject a voltage waveform into the device under test 48 to create test voltage conditions if the device under test 48 is controlled to inhibit current from flowing therethrough. This is because there is zero voltage developed across the inductor 38 when there is no rate of change of current in the inductor 38 due to current being inhibited from flowing through the device under test 48, as shown in Figure 8.

Creation of test voltage conditions may also be achieved by way of a second constructed synthetic test circuit 230 that is shown in Figure 9 and is designated generally by the reference numeral 230.

The second constructed synthetic test circuit 230 is constructed by connecting a chain-link converter 40, so that the second constructed synthetic test circuit 230 comprises first and second terminals and a voltage injection circuit in which the voltage injection circuit includes a voltage source, and the voltage source includes the chain-link converter 40; and the voltage injection circuit is connected across the first and second terminals. The second constructed synthetic test circuit 230 includes the controller 62 described above with reference to the first constructed synthetic test circuit 130.

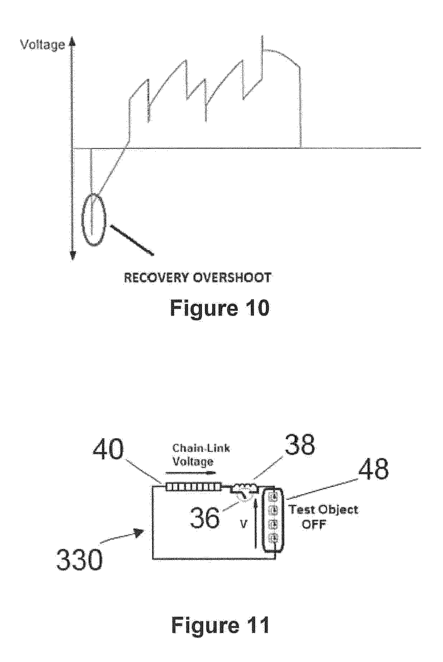

In the first constructed synthetic test circuit 130, the inductor 38 contributes an inductive impedance when the current injection circuit is operated to inject a current waveform into the device under test 48. The inductive impedance may be removed by way of a third constructed synthetic test circuit that is shown in Figure 11 and is designated generally by the reference numeral 330. The third constructed synthetic test circuit 330 is constructed by connecting a director switch 36 to the inductor 38 and chain-link converter 40, so that the third constructed synthetic test circuit 330 not only includes the structure of the first constructed synthetic test circuit 130 but also further includes a parallel connection of the inductor 38 and the director switch 36 in the current source. The third constructed synthetic test circuit 330 includes the controller 62 described above with reference to the first constructed synthetic test circuit 130.

The configuration of the third constructed synthetic test circuit 330 allows the director switch 36 to be operated to selectively form a current bypass path to allow, in use, a current waveform to bypass the inductor 38, thus permitting removal of the inductive impedance. This may be useful for an electrical test that requires the chain-link converter 40 to contribute a capacitive impedance.

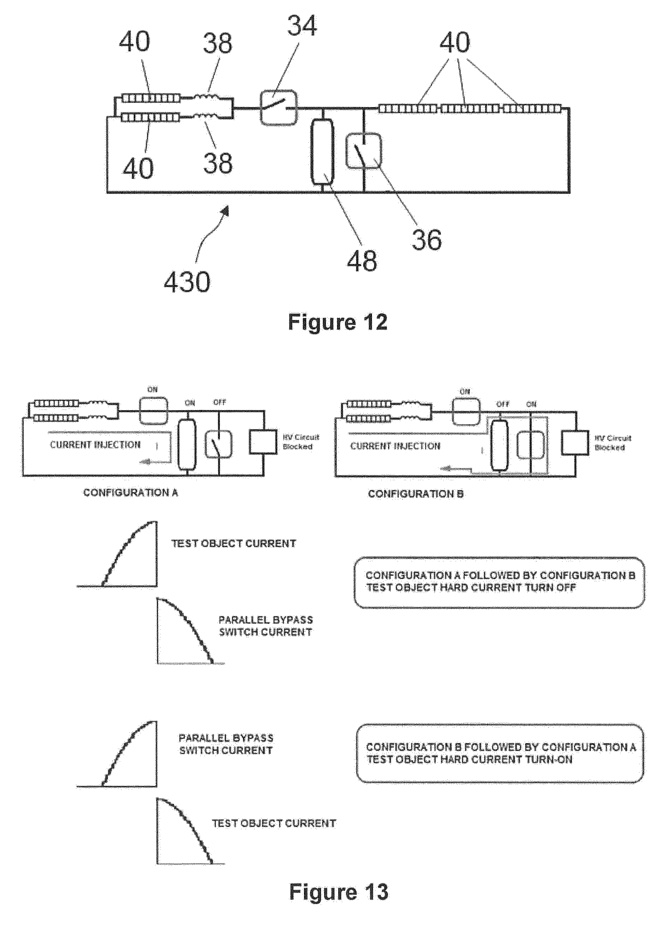

Creation of test current and voltage conditions may be achieved by way of a fourth constructed synthetic test circuit that is shown in Figure 12 and is designated generally by the reference numeral 430.

The fourth constructed synthetic test circuit 430 is constructed by connecting a plurality of chain-link converters 40, a plurality of inductors 38, the director switch 36 and thyristor valve 34, so that the fourth constructed synthetic test circuit 430 comprises first and second terminals, a current injection circuit, an isolation switch (i.e. the thyristor valve 34), a bypass switch (i.e. the director switch 36) and a voltage injection circuit. As shown in Figure 12, the current injection circuit is connected in series with the isolation switch between the first and second terminals, the bypass switch is connected between the first and second terminals and is thereby connected in parallel with the series connection of the current injection circuit and isolation switch, and the voltage injection circuit is connected in parallel with the bypass switch.

It can be seen from Figure 12 that the current injection circuit includes a plurality of parallel-connected current sources, each of which includes a series-connection of a chain-link converter 40 and an inductor 38, while the voltage injection circuit includes a plurality of series-connected voltage sources, each of which includes a chain-link converter 40. The number and configuration of sources in each of the current and voltage injection circuits may vary depending on the required current and voltage testing requirements of the device under test 48.

The fourth constructed synthetic test circuit 430 includes the controller 62 described above with reference to the first constructed synthetic test circuit 130. In addition the controller 62 is further configured to control turn-off of the isolation switch to switch the current injection circuit out of circuit with the first and second terminals so as to isolate the current injection circuit from the device under test 48 and the voltage injection circuit, and to control turn-on of the bypass switch to selectively form a current bypass path to allow, in use, a current waveform to bypass the voltage injection circuit. The provision of the isolation and bypass switches permits isolation between the current and voltage injection circuits, and thereby allows the current injection circuit to be configured as a low voltage, high current injection circuit and the voltage injection circuit to be configured as a low current, high voltage injection circuit.

In addition the bypass switch can be operated to selectively form a current bypass path to allow, in use, a current waveform to bypass the device under test 48. This allows a current waveform being injected by the current injection circuit into the device under test 48 to be commutated at a finite value into the current bypass path formed by the bypass switch, in order to create hard current switching test conditions for the device under test 48. Figure 13 illustrates the operation of the fourth constructed synthetic test circuit 430 to create a hard current turn-off test condition and a hard current turn-on test condition for the device under test 48.

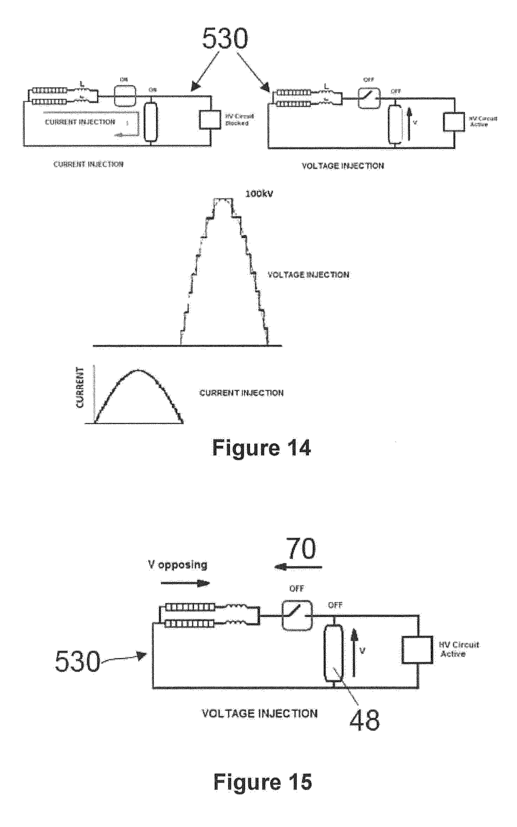

Figure 14 shows schematically the configuration of a fifth constructed synthetic test circuit 530. The fifth constructed synthetic test circuit 530 is similar in structure to the fourth constructed synthetic test circuit 430, except that the bypass switch is not connected to construct the fifth constructed synthetic test circuit 530. This is because the current bypass path selectively provided by the bypass switch is not required for creating soft current switching test conditions. In the absence of the bypass switch, the voltage injection circuit is operated to inject a voltage waveform into the device under test 48 after the current in the device under test 48 has reached zero.

During the operation of the voltage injection circuit to inject a voltage waveform into the device under test 48, the isolation switch experiences a voltage stress 70 imposed by the injection of the voltage waveform. The voltage rating required of the isolation switch may be reduced by an amount equivalent to an opposing voltage that can be provided by the chain-link converter 40 of the current injection circuit, as shown in Figure 15. In other words, the voltage rating of the isolation switch is the difference between the voltage applied by the voltage injection circuit and the opposing voltage provided from the chain link converter of the current injection circuit.

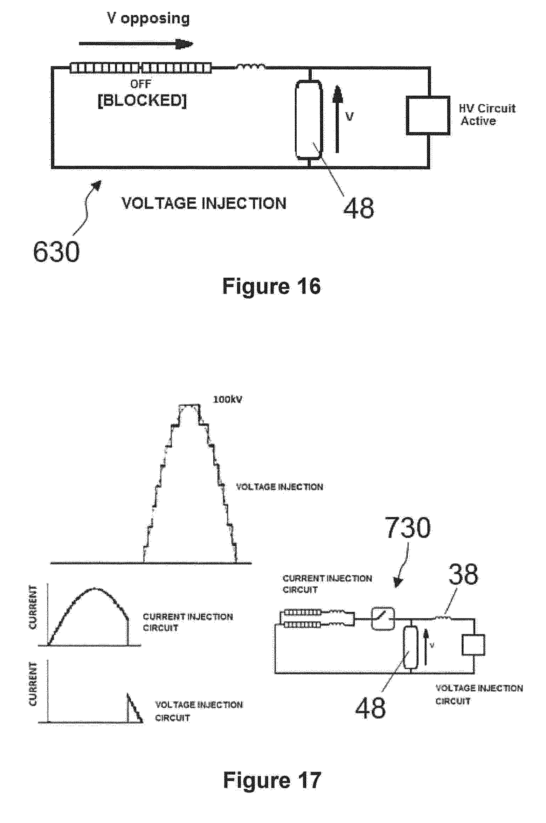

Figure 16 shows schematically the configuration of a sixth constructed synthetic test circuit 630. The sixth constructed synthetic test circuit 630 is similar in structure to the fifth constructed synthetic test circuit 530, except that the isolation switch is not connected to construct the sixth constructed synthetic test circuit 630. This is because the voltage rating of the chain-link converter 40 of the current injection circuit is set to be equal or higher than the voltage rating of the chain-link converter 40 of the voltage injection circuit, and so isolation of the current injection circuit from the voltage injection circuit can be achieved through configuration of the modules of the chain-link converter 40 of the current injection circuit to form a plurality of series-connected diode rectifiers in order to block current from flowing therethrough.

Figure 17 shows schematically the configuration of a seventh constructed synthetic test circuit 730. The seventh constructed synthetic test circuit 730 is similar in structure to the fifth constructed synthetic test circuit 530, except that a further inductor 38 is connected to construct the seventh constructed synthetic test circuit 730 in which the voltage source of the voltage injection circuit includes a series-connection of the inductor 38 and chain-link converter 40.

In use, the current and voltage injection circuits of the seventh constructed synthetic test circuit 730 may be operated so that the current injection circuit provides part of a current waveform injected into the device under test 48 (preferably during a period in which low voltage stress test conditions are required) and the voltage injection circuit provides part of a current waveform injected into the device under test 48 (preferably during a period in which low current loading test conditions is required). Figure 17 illustrates the sharing of the task of injecting the current waveform into the device under test 48 between the current and voltage injection circuits. It can be seen from Figure 17 that there is now an extended period of time between the point in time when conduction of the current injection circuit ends and the point in time when the forward (positive) voltage is applied. The provision of such an extended period of time is particularly useful when the isolation switch is slow to turn off, as can happen with large thyristor valves that can require 200-300 μs to turn off.

Figure 18 shows schematically the configuration of an eighth constructed synthetic test circuit 830. The eighth constructed synthetic test circuit 830 is similar in structure to the fifth constructed synthetic test circuit 530, except that a further thyristor valve 34 and a further plurality of chain-link converters 40 are connected to construct the eighth synthetic test circuit so that the voltage injection circuit includes a first voltage source 72 with a series connection of a further isolation switch (i.e. the further thyristor valve 34) and chain-link converter 40, and a second voltage source 74 with a series connection of a plurality of series-connected chain-link converters 40. The first and second voltage sources 72,74 are connected in parallel with each other.

In use, the further isolation switch permits selective isolation between the first and second voltage sources 72,74, while the second voltage source 74 permits selective injection of high magnitude voltage impulses into the device under test 48 in addition to the voltage waveform injected by the first voltage source 72.

Figure 19 shows schematically the configuration of part of a ninth constructed synthetic test circuit 930. The ninth constructed synthetic test circuit 930 is similar in structure to the first constructed synthetic test circuit 130, except that the power supply unit 100 is connected to construct the ninth constructed synthetic test circuit 930 in which the power supply unit 100 is directly coupled with the capacitor of each module of the current injection circuit. The ninth constructed synthetic test circuit 930 includes the controller 62 described above with reference to the first constructed synthetic test circuit 130.

The power supply unit 100 includes a rectifier that connects an AC power bus to each capacitor to maintain the capacitor at a set voltage and offset losses. The use of each rectifier permits supply of power to and removal of energy from the corresponding capacitor. Since each rectifier may be operating at a different voltage with respect to the other capacitors and ground, a respective isolation transformer is preferably connected between each rectifier and the AC power bus.

Figure 20 shows schematically the configuration of a tenth constructed synthetic test circuit 1030. The tenth constructed synthetic test circuit 1030 is similar in structure to the sixth constructed synthetic test circuit 630, except that a power supply unit 102 is connected to construct the tenth constructed synthetic test circuit 1030 in which the power supply unit 102 is connected in series with the chain-link converter 40 in the current injection circuit.

The power supply unit 102 injects a direct voltage $V_{DC}$ which interacts with the direct current component $I_{DC}$ of the current waveform injected into the device under test 48 in order to provide injection of real power into the tenth constructed synthetic test circuit 1030. The chain-link converter 40 of the current injection circuit is operated to generate an alternating voltage waveform with a direct voltage component that is equal and opposite to that provided by the power supply unit. Since the power supply unit 102 and the chain-link converter 40 of the current injection circuit conduct the same current waveform, the power exported from the power supply unit 102 is imported into the chain-link converter 40. The imported power is then shared equally amongst the capacitors of the modules by selectively bypassing and inserting them into the chain-link converter 40 so that each capacitor receives the appropriate amount of energy to, for example, compensate for its respective power losses. It can be seen from Figure 20 that the voltage applied across the inductor 38 is unaffected by the transfer of power from the power supply unit to the chain-link converter 40 of the current injection circuit.

The use of the respective power supply unit 100,102 to construct the ninth and tenth constructed synthetic circuits 930,1030 permits stable performance of the chain-link converter 40 to generate a voltage waveform thereacross, since the power supply unit 100,102 provides power to the capacitors of the chain-link converter 40 to offset the loss of energy as a result of, for example, conduction and switching losses.

In view of the foregoing it is shown that the apparatus 30 of Figure 1 effectively defines a flexible circuit structure for the construction of the synthetic test circuit by way of bypass, disconnection and/or connection of each of the electrically interconnected elements 32, and therefore easily allows a variety of different possible configurations of the synthetic test circuit to be constructed. This provides an effective means for constructing the synthetic test circuit to suit the testing requirements of a given device under test 48 but also for re-constructing the synthetic test circuit to suit the testing requirements of a different device under test 48. This renders the apparatus 30 compatible with multiple devices under test 48 with different testing requirements and thereby obviates the need to build separate synthetic test circuits for performing different electrical tests, which would add cost, size and weight to the associated infrastructure.

It will be appreciated that the above type of chain-link converters 40 and the above exemplary converters for use in HVDC power transmission described in this specification are merely chosen to illustrate the working of the invention. Accordingly it will also be appreciated that the invention is intended to extend to other types of chain-link converters, and the use of the constructed synthetic test circuit to test a converter component that may be used in other types of power applications, which are not limited to the field of HVDC power transmission.

It will be also appreciated that the electrical tests and the shapes of the voltage and current waveforms described in this specification are merely chosen to illustrate the working of the invention. Accordingly it will also be appreciated that other electrical tests and other shapes of the voltage and current waveforms may be used with the constructed synthetic test circuit according to the invention.

It will be further appreciated that the above examples of devices under test 48 are merely chosen to illustrate the working of the invention. Accordingly it will also be appreciated that other devices under test 48 may be used with the constructed synthetic test circuit according to the invention.

**Claims**

1. An apparatus for constructing a synthetic test circuit, the apparatus comprising an assembly of electrically interconnected elements, at least one of the electrically interconnected elements being or including a chain-link converter, the chain-link converter including a plurality of modules, each module including at least one energy storage device, wherein each of the electrically interconnected elements is configurable to be selectively bypassed, disconnected and/or connected to construct, in use, a synthetic test circuit including at least one of the electrically interconnected elements and in which the synthetic circuit includes: a terminal connectable to a device under test; and an injection circuit operably connected to the terminal, the injection circuit including a source, the source including the chain-link converter, each module being operable to be selectively bypassed and inserted into the corresponding chain-link converter so as to generate a voltage across the chain-link converter and thereby enable the injection circuit to inject a current waveform and/or a voltage waveform into the device under test.

2. An apparatus according to Claim 1 wherein the synthetic test circuit includes a current injection circuit and/or a voltage injection circuit.

3. An apparatus according to any preceding claim wherein the chain-link converter includes at least one module in which the or each energy storage device is configured to selectively provide a bidirectional voltage source and/or at least one module in which the or each energy storage device is configured to selectively provide a unidirectional voltage source.

4. An apparatus according to any preceding claim wherein each of a plurality of the electrically interconnected elements is or includes a chain-link converter.

5. An apparatus according to Claim 4 wherein each of the electrically interconnected elements is configurable to be selectively bypassed, disconnected and/or connected to construct the synthetic test circuit in which the injection circuit includes a plurality of series-connected or parallel-connected sources, each source including a respective one of the plurality of chain-link converters.

6. An apparatus according to any preceding claim wherein at least one other of the electrically interconnected elements is or includes a switching element, and optionally wherein the switching element is a naturally commutated or self-commutated switching element.

7. An apparatus according to Claim 6 wherein each of the electrically interconnected elements is configurable to be selectively bypassed, disconnected and/or connected to construct the synthetic test circuit in which the switching element is connected in series or parallel with the injection circuit.

8. An apparatus according to Claim 6 or Claim 7 wherein each of the electrically interconnected elements is configurable to be selectively bypassed, disconnected and/or connected to construct the synthetic test circuit in which the switching element is operable to selectively form a current bypass path to allow, in use, a current waveform to bypass the device under test.

9. An apparatus according to any preceding claim wherein at least one other of the electrically interconnected elements is or includes an impedance element.

10. An apparatus according to Claim 9 wherein each of the electrically interconnected elements is configurable to be selectively bypassed, disconnected and/or connected to construct the synthetic test circuit in which the source of the injection circuit includes an interconnection of the impedance element and the chain-link converter.

11. An apparatus according to Claim 9 or Claim 10 when either claim is dependent on Claim 6 wherein each of the electrically interconnected elements is configurable to be selectively bypassed, disconnected and/or connected to construct the synthetic test circuit in which the source of the injection circuit includes an interconnection of the impedance element and the switching element, the switching element being operable to selectively form a current bypass path to allow, in use, a current waveform to bypass the impedance element.

12. An apparatus according to any preceding claim wherein at least one other of the electrically interconnected elements is or includes a power supply unit, and wherein each of the electrically interconnected elements is configurable to be selectively bypassed, disconnected and/or connected to construct the synthetic test circuit in which the power supply unit is coupled to the chain-link converter so as to permit the power supply unit to selectively charge the or each energy storage device.

13. An apparatus according to Claim 12 wherein each of the electrically interconnected elements is configurable to be selectively bypassed, disconnected and/or connected to construct the synthetic test circuit in which:

- the power supply unit is directly coupled with the or each energy storage device of each module; or
- the power supply unit is connected with the chain-link converter in the injection circuit, optionally the power supply unit is connected in series with the chain-link converter in the injection circuit.

14. A synthetic test circuit for performing an electrical test on a device under test, the synthetic test circuit including an apparatus according to any preceding claim.

15. A synthetic test circuit according to Claim 14 further including a controller, the controller being configured to operate each module to selectively bypass the or each corresponding energy storage device and insert the or each corresponding energy storage device into the corresponding chain-link converter so as to generate a voltage across the chain-link converter and thereby operate the injection circuit to inject a current waveform and/or a voltage waveform into the device under test.

**Figure 1**

34

36

40,42

40,44

40,46

38

**Figure 2**

48

48a   48b   48c   48d   48e

48f

48g   48h   48i

**Figure 3**

Figure 4

Figure 5

Figure 6

Figure 7

40 — Chain Link Voltage →   Inductor Voltage = 0 ← 38

130 →   I=0   dI/dt = 0   OFF   Test Object Voltage ↑

48

TEST OBJECT VOLTAGE
= CHAIN LINK VOLTAGE

## Figure 8

40 — Chain Link Voltage →   48

230 →   I=0   dI/dt = 0   OFF   Test Object Voltage ↑

TEST OBJECT VOLTAGE
= CHAIN LINK VOLTAGE

## Figure 9

Voltage

RECOVERY OVERSHOOT

**Figure 10**

40    Chain-Link
      Voltage                    38                    48

                                                   Test Object
                          36      V                OFF
330

**Figure 11**

Figure 12

Figure 13

530

Figure 14

70

530

48

Figure 15

V opposing

OFF
[BLOCKED]

HV Circuit
Active

V

VOLTAGE INJECTION

630

48

**Figure 16**

100kV

VOLTAGE INJECTION

CURRENT

CURRENT INJECTION
CIRCUIT

CURRENT

VOLTAGE INJECTION
CIRCUIT

CURRENT INJECTION
CIRCUIT

730

38

V

VOLTAGE INJECTION
CIRCUIT

48

**Figure 17**

830

CURRENT
INJECTION

34

IMPULSE
VOLTAGE
INJECTION

V

48

VOLTAGE
INJECTION

72

74

Figure 18

AC Power Bus

Isolation Transformer

Rectifier

100

40

CURRENT INJECTION CIRCUIT

930

Figure 19

40

$V_{MMC} - V_{DC}$    Inductor Voltage    38

$V_{DC}$    $I_{DC}$    ON    HV Circuit

102    48

1030

$I_{DC}$  Current

Chain Link Voltage
[DC Biased]

Power Supply Voltage
[DC Biased]

Inductor Voltage

Figure 20

Europäisches
Patentamt

European
Patent Office

Office européen
des brevets

# EUROPEAN SEARCH REPORT

**Application Number**

EP 14 27 5212

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 755 315 A1 (ALSTOM TECHNOLOGY LTD [CH]) 16 July 2014 (2014-07-16) * paragraphs [0001] - [0006], [0047] - [0078], [0097] - [0134]; claims 1-3,6-7,9-15; figures 1a-1c,2,4,11-13 * | 1,2,12, 13 | INV. G01R31/333 H02M7/483 |
| X | WO 2010/145692 A1 (ABB TECHNOLOGY AG [CH]; ASPLUND GUNNAR [SE]) 23 December 2010 (2010-12-23) * page 1, line 9 - page 4, line 22; claims 1-3,8-14; figures 1-4 * * page 11, line 14 - page 15, line 32 * | 1,2,12, 13 | |
| X | WO 2012/055435 A1 (ALSTOM GRID UK LTD [GB]; GREEN TIMOTHY CHARLES [GB]; MERLIN MICHAEL MA) 3 May 2012 (2012-05-03) * page 1, line 3 - page 3, line 4; claims 1-7,10-12,15-24; figures 14-,5a,5b,6,8,9,11 * * page 11, line 24 - page 23, line 13 * | 1,2,12, 13 | |

TECHNICAL FIELDS
SEARCHED     (IPC)

G01R
H02M

~~The present search report has been drawn up for all claims~~

| Place of search | Date of completion of the search | Examiner |
|---|---|---|
| Munich | 22 June 2015 | Bilzer, Claus |

EPO FORM 1503 03.82 (P04C01)

Europäisches
Patentamt

European
Patent Office

Office européen
des brevets

Application Number

EP 14 27 5212

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1, 2, 12, 13

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 14 27 5212

The Search Division considers that the present European patent application does not comply with the
requirements of unity of invention and relates to several inventions or groups of inventions, namely:

```
1. claims: 1, 2

        apparatus for constructing a synthetic test circuit and
        details of the synthetic test circuit with respect to an
        injection circuit.
                            ---

2. claims: 3-5

        apparatus for constructing a synthetic test circuit and
        details of the chain-link converter.
                            ---

3. claims: 6-8

        apparatus for constructing a synthetic test circuit, said
        apparatus comprising a switching element as an electrically
        interconnected element.
                            ---

4. claims: 9-11

        apparatus for constructing a synthetic test circuit, said
        apparatus comprising an impedance element as an electrically
        interconnected element.
                            ---

5. claims: 12, 13

        apparatus for constructing a synthetic test circuit, said
        apparatus comprising a power supply as an electrically
        interconnected element.
                            ---

6. claims: 14, 15

        synthetic test circuit.
                            ---
```

## ANNEX TO THE EUROPEAN SEARCH REPORT
## ON EUROPEAN PATENT APPLICATION NO.

EP 14 27 5212

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2015

| Patent document cited in search report | | Publication date | Patent family member(s) | | Publication date |
|---|---|---|---|---|---|
| EP 2755315 | A1 | 16-07-2014 | EP | 2755315 A1 | 16-07-2014 |
| | | | WO | 2014108258 A2 | 17-07-2014 |
| WO 2010145692 | A1 | 23-12-2010 | CN | 102460195 A | 16-05-2012 |
| | | | EP | 2443468 A1 | 25-04-2012 |
| | | | KR | 20120025531 A | 15-03-2012 |
| | | | WO | 2010145692 A1 | 23-12-2010 |
| WO 2012055435 | A1 | 03-05-2012 | CA | 2815394 A1 | 03-05-2012 |
| | | | CN | 103283140 A | 04-09-2013 |
| | | | EP | 2633612 A1 | 04-09-2013 |
| | | | KR | 20130132451 A | 04-12-2013 |
| | | | US | 2013279211 A1 | 24-10-2013 |
| | | | WO | 2012055435 A1 | 03-05-2012 |

EPO FORM P0459

For more details about this annex : see Official Journal of the European Patent Office, No. 12/82